# EUROPÄISCHE PATENTSCHRIFT

(11) **EP 1 604 390 B1**
(45) Veröffentlichungstag und Bekanntmachung des Hinweises auf die Patenterteilung: **14.04.2010**
(21) Anmeldenummer: 04708713.5
(22) Anmeldetag: 06.02.2004
(51) Int. Cl.: H01L 21/20, H01L 21/265

(54) **VERFAHREN ZUR HERSTELLUNG EINER SPANNUNGSRELAXIERTEN SCHICHTSTRUKTUR AUF EINEM NICHT GITTERANGEPASSTEN SUBSTRAT SOWIE VERWENDUNG EINES SOLCHEN SCHICHTSYSTEMS IN ELEKTRONISCHEN UND/ODER OPTOELEKTRONISCHEN BAUELEMENTEN**
METHOD FOR THE PRODUCTION OF STRESS-RELAXED LAYER STRUCTURE ON A NON-LATTICE ADAPTED SUBSTRATE AND UTILIZATION OF SAID LAYER SYSTEM IN ELECTRONIC AND/OR OPTOELECTRONIC COMPONENTS
PROCEDE DE PRODUCTION D'UNE STRUCTURE LAMELLAIRE LIBERANT LA CONTRAINTE SUR UN SUBSTRAT NON ADAPTE EN GRILLE ET UTILISATION D'UN TEL SYSTEME LAMELLAIRE DANS DES COMPOSANTS ELECTRONIQUES ET/OU OPTOELECTRONIQUES

(30) Priorität: 10.03.2003 DE 10310740
(43) Veröffentlichungstag der Anmeldung: 14.12.2005
(73) Patentinhaber: Forschungszentrum Jülich GmbH, 52425 Jülich (DE)
(72) Erfinder: MANTL, Siegfried, 52428 Jülich (DE)
(86) Internationale Anmeldenummer: PCT/DE2004/000200
(87) Internationale Veröffentlichungsnummer: WO 2004/082001

(56) Entgegenhaltungen:
- EP-A- 1 351 284
- WO-A-02/15244
- WO-A-03/069658
- WO-A-03/092058
- US-A- 6 039 803
- US-A1- 2002 017 642

## Beschreibung

Die Erfindung betrifft ein Verfahren zur Herstellung eines Schichtsystems, umfassend eine spannnungsrelaxierte, einkristalline Schichtstruktur auf einem Substrat, mit jeweils unterschiedlicher Gitterstruktur. Ferner betrifft die Erfindung die Verwendung eines solchen Schichtsystems in elektronischen und/oder optoelektronischen Bauelementen. Im Speziellen dient das Verfahren zur Herstellung einer verspannten Schicht, wie z. B. von verspanntem Silizium, auf einem dünnen spannungsrelaxierten Schichtsystem z. B. bestehend aus Silizium-Germanium.

### Stand der Technik

Die rasch fortschreitende Nanoelektronik erfordert stetig schnellere Transistoren, insbesondere metal oxide field effect transistors (MOSFETs). Eine Leistungssteigerung wird in der Regel durch Verkleinerung der Transistordimensionen erzielt. Dies ist aber sehr aufwendig und teuer, da die Schlüsseltechnologien der Chip-Herstellung, wie die Lithographieverfahren und die Ätzverfahren durch leistungsfähigere Systeme ersetzt werden müssen. Ein alternativer Weg, ist die Verwendung von leistungsfähigeren Materialien. Hier bietet sich insbesondere der Einsatz von verspanntem Silizium, verspanntem Silizium-Germanium (Si-Ge) bzw. Silizum-Kohlenstoff (Si-C) und Silizium-Germanium-Kohlenstoff (Si-Ge-C) an. Solch elastisch verspannte Schichtsysteme setzen allerdings epitaktisches Wachstum auf speziellen Substraten, bzw. auf spannungsrelaxierten Schichten, sogenannten "virtuellen Substraten" voraus, deren Herstellung mit geringer Defektdichte sehr aufwendig und schwierig ist. (F. Schaeffler, Semiconductor Sci. Techn. 12 (1997) p. 1515-1549).

Häufig wird nämlich die Herstellung einkristalliner Schichten durch das zur Verfügung stehende Substratmaterial stark begrenzt, bzw. die Qualität der Schichten vermindert. Unterschiedliche Kristallstrukturen, sowie unterschiedliche Gitterparameter zwischen Substrat und Schichtmaterial (Gitterfehlanpassung) verhindern in der Regel ein einkristallines Wachstum von Schichten hoher Qualität. Werden bei nicht angepassten Gitterparametern einkristalline Schichten abgeschieden, so hat dies zur Folge, dass diese anfangs mechanisch verspannt aufwachen, d. h. deren Gitterstruktur unterscheidet sich in diesem Zustand von der eigenen. Überschreitet die abgeschiedene Schicht einen bestimmten Verspannungsgrad, so wird die mechanische Spannung durch Versetzungsbildung abgebaut und die Gitterstruktur kommt der eigenen näher. Diesen Prozess nennt man Spannungsrelaxation, im Folgenden "Relaxation" genannt.

Bei Schichtdicken, die für Bauelemente häufig erforderlich sind, werden durch diese Relaxation Versetzungen an der Grenzfläche zwischen der gebildeten Schicht und dem Substrat eingebaut, wobei aber auch nachteilig viele Versetzungen, von der Grenzfläche bis zur Schichtoberfläche verlaufen (sog. Threading-Versetzungen). Da sich die meisten dieser Versetzungen weiter durch neu aufgewachsene Schichten hindurch fortsetzen, verschlechtern sie die elektrischen und optischen Eigenschaften des Schichtmaterials erheblich.

Die Verwendung von Silizium bzw. Siliziumgermanium (Si-Ge), Silizum-Kohlenstoff (Si-C), oder Silizium-Germanium-Kohlenstoff (Si-Ge-C) in einem bestimmten elastischen Verzerrungszustand verbessert die Materialeigenschaften, insbesondere die für Bauelemente eminent wichtige Ladungsträgerbeweglichkeit der Elektronen und Löcher. Der Einsatz dieser und anderer höherwertigen Materialien erlaubt eine erhebliche Performancesteigerung von Si basierten Hochleistungsbauelementen, wie MOSFET und MODFETs, ohne die kritischen Strukturgrößen der Bauelemente verändern zu müssen. Um allerdings mit dem gleichen Schichtsystem neben einer erhöhten Elektronenbeweglichkeit auch eine wesentliche Verbesserung der Löcherbeweglichkeit zu erzielen, muss nach Oberhuber et al., Physical Review B 58(15) (1998) p. 9941-9948 die tetragonale Verzerrung in verspanntem Silizium größer als etwa 1,3 % sein. Dies lässt sich demnach dadurch realisieren, dass verspanntes Silizium auf einem "virtuellen Substrat", z. B. bestehend aus einer zu 100 % relaxierten Si-Ge-Schicht mit mindestens 30 Atom-% Ge, epitaktisch aufgebracht wird.

Da das Siliziumgermanium- (SiGe)-Materialsystem thermodynamisch ein völlig mischbares System ist, kann die Verbindung in beliebiger Konzentration hergestellt werden. Silizium und Germanium zeichnen sich zwar durch gleiche Kristallstrukturen aus, unterscheiden sich aber im Gitterparameter um 4,2 %, d. h. dass eine SiGe-Schicht oder eine reine Ge-Schicht auf Silizium verspannt aufwächst. Kohlenstoff kann in Silizium nur bis zu ca. 2 Atom-% substitutionell eingebaut werden, um den Gitterparameter zu verkleinern.

Stand der Technik zur Herstellung von beispielsweise verspannungsfreien, qualitativ hochwertigen Siliziumgermanium- (SiGe)-Legierungsschichten auf Silizium-Substrat ist der Einsatz sog. "graded layer". Hierbei handelt es sich um SiGe-Schichten, deren Ge-Konzentration zur Oberfläche hin bis zur Erreichung des gewünschten Ge-Gehalts kontinuierlich oder stufenweise zunimmt. Da zur Einhaltung der Schichtqualität nur ein Anstieg des Ge-Gehalts von ca. 10 Atom-% pro µm eingesetzt werden kann, sind solche Schichten, je nach erreichter Ge-Konzentration bis zu 10 Mikrometer dick. Für das Schichtwachstum ist dies aus wirtschaftlicher und technologischer Sicht nicht befriedigend.

Das Schichtwachstum dieser "graded layer" wird in E. A. Fitzgerald et al., Thin Solid Films, 294 (1997) 3-10, beschrieben. Zudem führt dieses Verfahren zu hohen Schichtrauhigkeiten, zu Versetzungsmultiplikation und so zu kristallographischen Verkippungen von Bereichen, so dass ein aufwendiges Polieren der Schichten erforderlich wird.

Aus Leitz et al., Applied Physics Letters, Vol. 79(25) (2001), p. 4246-4248 sowie aus Cheng et al., Mat. Res. Soc. Symp., Vol. 686 (2002) Al.5.1- A1.5.6 sind Verfahren zur Herstellung von Strukturen mit Waferbonden und Ätzen vorgestellt. Nachteilig sind diese Verfahren teuer und technologisch sehr aufwendig, da viele sehr anspruchsvolle Prozessschritte umfasst sind.

In WO 99/38201 wurde bereits ein Verfahren vorgestellt, das die Herstellung von dünnen spannungsrelaxierten Si-Ge-Pufferschichten erlaubt. Nachteilig an diesem Verfahren ist allerdings, dass der erzielbare Relaxationsgrad relativ klein ist (typischerweise 50 - 70 %), dieser mit zunehmendem Ge-Gehalt stark abnimmt und die Versetzungsdichte in der relaxierten Si-Ge Schicht relativ hoch ist. Beispielsweise wurde für eine 28 Atom-% germaniumhaltige, 100 nm dicke Si-Ge-Schicht eine Versetzungsdichte im Bereich von 10⁷ cm⁻² bestimmt (Luysberg et al.; Journal of Applied Physics 92 (2002) p. 4290). Besonders eingeschränkt wird das Verfahren bei noch höheren Ge-Konzentrationen, da die Schichtdicke der zu relaxierenden Si-Ge-Schicht dann noch kleiner (< 100 nm) gehalten werden muss. Dies ist erforderlich, da sich ansonsten bereits während des Wachstums Versetzungen bilden.

Der erreichbare Relaxationsgrad und somit auch die minimale Versetzungsdichte hängen in homogenen Si-Ge-Schichten stark von der Schichtdicke ab, da die Kraft, die auf eine Fadenversetzung wirkt, proportional zur Schichtdicke ist.

### Aufgabe und Lösung

Aufgabe der Erfindung ist es ein Verfahren zur Herstellung einer spannungsrelaxierten Schichtstruktur auf einem nicht gitterangepassten Substrat, wie z. B einem Si-Ge Schichtpaket auf einem Silizium-Substrat oder einem Silicon on Insulator (SOI) Substrat, bereit zu stellen, das die im Stand der Technik aufgezeigten Mängel nicht aufweist.

Insbesondere soll in einer vorteilhaften Ausgestaltung verspanntes Si auf unverspanntes Siliziumgermanium (Si-Ge) oder anderen geeigneten Materialien mit jeweils unterschiedlicher Gitterstruktur hergestellt werden, die vorteilhaft unter Gewährleistung der Planarität für die weitere Prozessierung von Bauteilen erforderlich benötigt werden.

Ferner ist es Aufgabe der Erfindung elektronische und/oder optoelektronische Bauteile zur Verfügung zu stellen, die die obengenannte vorteilhafte Schichtstruktur aufweisen.

Die Aufgabe der Erfindung wird durch ein Herstellungsverfahren gemäß Hauptanspruch gelöst. Vorteilhafte Ausgestaltungen ergeben sich aus den darauf rückbezogenen Patentansprüchen. Ferner wird die Aufgabe durch die Verwendung der hergestellten Schichtstruktur in Bauteilen gemäß der Nebenansprüche gelöst.

### Gegenstand der Erfindung

Im Rahmen der Erfindung wurde überraschend gefunden, dass eine sehr gut relaxierende Schichtstruktur auf einem nicht gitterangepassten Substrat, anders als bislang üblich, durch Aufbringen einer Schichtstruktur ausgebildet werden kann, die eine relativ hohe Gitterparameterfehlanpassung Δf₁ an der Grenze zum Substrat aufweist. Diese Gitterparameterfehlanpassung an der Grenze zum Substrat sollte mindestens 1,5 %, vorteilhaft sogar mehr als 2 %, insbesondere sogar ca. 4 % betragen. Beispiele einer solchen Schichtenfolge mit einer entsprechend hohen Gitterparameterfehlanpassung sind u. a. ein Si-Substrat mit einer aufgebrachten Ge-Schicht oder ein Si-Substrat mit einer aufgebrachten Si-Ge-Schicht mit mindestens 30 Atom.-% Ge-Gehalt.

Neben der hohen Gitterparameterfehlanpassung Δf₁ an der Grenze zum Substrat weist die Schichtstruktur in dem mittleren Bereich der Schichtstruktur eine Zusammensetzung mit einer weiteren Gitterparameterfehlanpassung Δf₂ auf, die gegenüber dem Substrat kleiner ist als Δf₁, vorteilhaft sogar nur halb so hoch. Eine solche Schichtstruktur weist daher entweder wenigstens zwei konkrete Schichten mit unterschiedlichen Zusammensetzungen und unterschiedlichen Gitterparameterfehlanpassungen (Δf₁ und Δf₂) gegenüber dem Substrat auf, oder aber wenigstens eine gradiert aufgebaute Schicht, bei der die Germaniumkonzentration senkrecht zur Substratoberfläche variiert.

Beispiele für eine geeignete zweischichtige Schichtstruktur (Abfolge: erste Schicht, die an das Substrat angrenzt, zweite Schicht) sind u. a. Germanium - Si-Ge, oder Si₁₋ₓGeₓ - Si_{1-y}Ge_{y} mit x > y, oder auch GeC - SiGe. Im allgemeinen können diese Schichten auch noch zusätzlich 1-2 Atom-% Kohlenstoff aufweisen.

Eine erste vorteilhafte Variation der Germaniumkonzentration in einer gradierten Schicht der Schichtstruktur ist eine kontinuierlich abfallende Konzentration von der Grenzfläche Substrat/Schichtstruktur zur Oberfläche der Schichtstruktur hin. In diesem Fall bedeutet Δf₂ die Gitterparameterfehlanpassung der Oberflächenzusammensetzung der Schichtstruktur gegenüber dem Substrat.

Eine weitere vorteilhafte Variation ist die Ausbildung eines U-Profils, bei dem die Germaniumkonzentration an der Grenzfläche Substrat/Schichtstruktur und an der Oberfläche der Schichtstruktur höher ist, als in dem mittleren Bereich der Schichtstruktur. In diesem Fall

bedeutet Δf₂ die Gitterparameterfehlanpassung der Zusammensetzung in dem mittleren Bereich der Schichtstruktur, bzw. die der Zusammensetzung mit dem geringsten Ge-Gehalt in der Schichtstruktur gegenüber dem Substrat.

Als besonders geeignete Materialien für eine gradierte Schichtstruktur sind insbesondere Si-Ge, Si-C und Si-Ge-C zu nennen.

Die Gesamtschichtdicke der epitaktischen Schichtstruktur ist so zu wählen, dass eine bestimmte Dicke, bei der die Versetzungen eine Dichte von mehr als 10³/cm² (Defektdichte) aufweisen, unterschritten wird. Bei einer mehrschichtigen Schichtstruktur muss zudem sichergestellt sein, dass die erste, an das Substrat angrenzende Schicht eine Schichtdicke aufweist, die kleiner ist als die sogenannte kritische Schichtdicke für diese Schicht. Die kritische Schichtdicke definiert die maximale Schichtdicke für diese Schicht, bei der noch ein defektfreies Wachstum auf dem nicht gitterangepassten Substrat möglich ist. Bei einer Schichtdicke unterhalb dieser kritischen Schichtdicke kann daher in der Regel streng pseudomorphes, d. h. völlig defektfreies Wachstum erzielt werden.

Die Schichtdicke der abzuscheidenden, ersten Schicht wird ein Fachmann danach auslegen, wie groß die kritische Schichtdicke, bzw. wie groß die Gitterparameterfehlanpassung ist. Im Allgemeinen gilt, je höher die Gitterparameterfehlanpassung, desto geringer die kritische Schichtdicke. Bei den hier aufgeführten Materialien liegt die Schichtdicke einer ersten Schicht in der Regel zwischen 1 und 20 nm, vorteilhaft zwischen 1 und 15 nm. Bei der Kombination Si-Substrat und eine darauf aufgebrachte reine Germaniumschicht beträgt die geeignete Schichtdicke der Germaniumschicht sogar nur 3 bis 4 nm. Bei einem dreischichtigen Aufbau der Schichtstruktur gilt dies entsprechend sowohl für die erste, als auch für die dritte Schicht.

Die Schichtdicke der zweiten Schicht wird in der Regel deutlich höher gewählt (50 bis 400 nm). Wichtig ist nur, dass die Gesamtschichtdicke der Schichtstruktur derart klein gehalten wird, dass die Versetzungsdichte regelmäßig kleiner als 10³/cm² ist.

Im Rahmen dieser Erfindung hat sich herausgestellt, dass eine solche, vorgenannte epitaktisch aufgebrachte, einkristalline Schichtstruktur oberhalb eines vergrabenen, durch Ionenimplantation in der Substratschicht erzeugten Defektbereichs, bei einer thermischen und/oder oxidativen Behandlung sehr gut spannungsrelaxiert. Dies gilt insbesondere bei dem Einsatz von Materialien für die Schichtstruktur, die gegenüber den im Stand der Technik eingesetzten Materialien eine relativ hohe Gitterfehlanpassung im Bezug auf das Substrat aufweisen.

Der Anteil der erfindungsgemäßen spannungsrelaxierten Schichtstruktur liegt nach einer thermischen und/oder oxidativen Behandlung in der Regel höher als 60 %, insbesondere höher als 70 %. Eine solche Schichtstruktur mit einem hohen Grad an Relaxation und einer sehr kleinen Versetzungsdichte wird auch "virtuelles Substrat" genannt.

In einer ersten Ausgestaltung des Verfahrens geht man von einer Schichtenfolge auf einem Substrat aus, auf dem mindestens zwei epitaktische Schichten mit unterschiedlicher chemischer Zusammensetzung und unterschiedlicher Schichtdicke epitaktisch abgeschieden werden, wobei die erste Schicht mit einer Schichtdicke d₁ eine große Änderung des Gitterparameters und somit eine große elastische Verzerrung zum Substrat aufweist. Die erste Schicht kann beispielsweise eine nur wenige Monolagen dicke reine Germaniumschicht auf Silizium oder eine Si-Ge-Schicht mit hohem Ge-Gehalt auf Silizium sein. Die Schichtdicke der ersten Schicht d₁ (z. B. d₁ = 1 - 20 nm) muss kleiner als die sogenannte kritische Schichtdicke sein, damit defektfreies Wachstum möglich ist. Darauf wird dann beispielsweise eine zweite, wesentlich dickere Si-Ge-Schicht mit einer bestimmten Konzentration z. B. 30 Atom.-% Ge und einer Schichtdicke d₂ (d₂ >> d₁; z. B. 50 nm < d₂ < 400 nm) abgeschieden. Die Gesamtschichtdicke d₁ und d₂ darf dabei jene kritische Dicke nicht überschreiten, bei der Versetzungen mit einer Dichte > 10³ cm⁻² während des Wachstums entstehen. Dies impliziert, dass die Gesamtschichtdicke auch über der sogenannten "kritischen Schichtdicke", die streng pseudomorphes, d. h. völlig defektfreies Wachstum garantiert, liegen darf.

Bei einer alternativen Ausführungsform des Verfahrens zu dem vormals erwähnten Zweischicht-System, wird eine epitaktische Schicht mit einem kontinuierlich verlaufenden Konzentrationsgradienten auf dem Substrat abgeschieden. Das Konzentrationsgefälle kann dabei sowohl stetig, als auch beispielsweise U-förmig verlaufen.

Alternativ kann bei dem Verfahren auch ein Dreischichtsystem in Anlehnung an das 2-Schichtsystem erzeugt werden. Dabei wird auf die erste Schicht und die zweite Schicht eine weitere dritte Schicht aufgebracht. Diese weist ähnlich wie die erste Schicht eine hohe Konzentration und eine kleine Schichtdicke auf. Dadurch kann, ähnlich wie in der Ausführungsform mit dem U-förmigen Konzentrationsprofil, eine symmetrische Spannungsverteilung in der Schichtstruktur erzeugt werden.

Die Verwendung dieser speziellen Schichtsysteme hat zum Ziel, die für die Relaxation bestimmenden Schichtparamter so zu optimieren, dass ein wesentlich höherer Relaxationsgrad und somit eine kleinere Versetzungsdichte in dem so erzeugten virtuellen Substrat auch bei größerer Gitterfehlanpassung (z. B. bei höherer Ge-Konzentration) nach geeigneter Ionenimplantation und thermischer Behandlung erreicht werden kann. Die plastische Relaxation durch Versetzungen hängt von der Schichtdichte und der jeweiligen Verspannung ab.

Anders als beim Stand der Technik, wo Pufferschichten mit gradiertem Ge-Gehalt eingesetzt werden, wobei das Wachstum an der Grenzfläche zum Substrat in der Regel mit einem kleinen Ge-Gehalt begonnen wird und nur schrittweise erhöht wird, um die Gitterparameteränderungen bewusst klein zu halten, wird im Rahmen der Erfindung ein ganz neuer Ansatz zur Herstellung solcher vorteilhaften Schichtstrukturen gewählt.

Innerhalb eines sehr dünnen Schichtbereiches (entweder erste Schicht in einer zwei oder dreischichtigen Schichtstruktur oder Anfangsbereich einer gradierten Schichtstruktur) wird die elastische Gitterverzerrung an der Substratgrenzfläche durch geeignete Wahl der Schichtkomposition hoch angesetzt. In einem sich daran anschließenden Bereich (zweite Schicht in einer zwei oder dreischichtigen Schichtstruktur oder Mittel- bzw. Oberflächenbereich einer gradierten Schichtstruktur) wird die Komposition entweder sofort oder graduell auf den Ge-Gehalt abgesenkt für den die erwünschte Relaxation erzielt werden soll. Dieser Effekt kann durch einen dritten Bereich (dritte Schicht einer dreischichtigen Schichtstruktur mit hoher Ge-Konzentration oder Oberflächenbereich einer gradierten (Schichtstruktur mit U-Profil) verstärkt werden.

Der zu erzielende Effekt, dass im Anfangsbereich zwischen Substrat und Schichtstruktur eine relativ hohe Gitterverzerrung auftritt, kann im Rahmen der Erfindung nicht nur durch das Aufbringen einer ersten Schicht mit hoher Gitterparameterfehlanpassung bezüglich des Substrates realisiert werden, sondern auch dadurch, dass das Substrat selbst durch Einbringen von Kohlenstoff eine gegenüber der Schichtstruktur erhöhte Gitterparameterfehlanpassung, aufweist.

Mit dem erfindungsgemäßen Verfahren kann eine überwiegend relaxierte Schichtstruktur erzeugt werden, die zudem vorteilhaft eine geringe Oberflächenrauhigkeit von regelmäßig weniger als 1 mm und nach dem Wachstum nur eine geringe Defektdichte von weniger als 10⁶ cm², insbesondere von weniger als 10⁵ cm⁻² aufweist. Dies ist besonderes vorteilhaft für das Aufbringen weiterer verspannter Schichten auf diese Schichtstruktur.

Um in einer vorteilhaften Ausgestaltung des Verfahrens verspanntes Silizium zu erzeugen oder auch einen Schutz des Schichtsystems zu erreichen, kann zusätzlich eine weitere, dünne Schicht epitaktisch auf der Schichtstruktur abgeschieden werden. Dazu ist insbesondere epitaktisches Silizium geeignet. Diese Abscheidung kann, wenn die Schichtdicke ausreichend klein ist, vor oder nach oder zwischen den folgenden Prozessschritten der Ionenimplantation und der thermischen Behandlung erfolgen.

Gemäß dem Hauptanspruch des erfindungsgemäßen Verfahrens wird anschließend primär unterhalb dieser epitaktischen Schichtstruktur durch eine Ionenimplantation ein Defektbereich erzeugt. Je nach Schichtdicke, Ionensorte, -energie und -dosis wird auch die epitaktische Schichtstruktur dabei geschädigt. Die Implantationsbedingungen werden derart gewählt, dass in der Regel keine vollständige Amorphisierung der epitaktischen Schichtstruktur erfolgt und die Defekte in der epitaktischen Schichtstruktur weitestgehend ausgeheilt werden können.

Diese Schichtenfolge aus Substrat mit Defektbereich und aufgebrachter Schichtstruktur und gegebenenfalls einer weiteren epitaktisch aufgebrachten Schicht wird dann thermisch so behandelt, so dass die Schichtstruktur, die das virtuelle Substrat darstellt, oberhalb des Defektbereichs spannungsrelaxiert. Dadurch erhält man unmittelbar mindestens eine epitaktische Schichtstruktur mit geändertem Verspannungszustand auf einem Substrat.

Die Implantation kann optional auch unter Verwendung einer Implantationsmaske nur in Teilbereichen des Substrates, insbesondere eines Wafers erfolgen. In einem solchen Fall wird der Verspannungszustand der epitaktischen Schichtstruktur im wesentlichen nur oberhalb der implantierten Defektbereiche relaxieren.

Mit unterschiedlicher Gitterstruktur werden im Rahmen dieser Erfindung Materialien mit verschiedenen Gitterparametern oder verschiedenen Kristallstrukturen verstanden.

Die vorgenannte Schichtenfolge aus Substrat/Defektbereich und epitaktischer Schichtstruktur kann auf verschiedene Wege hergestellt werden. Es kann beispielsweise auf einem Substrat epitaktisch eine Schichtstruktur abgeschieden werden und anschließend (partiell) ein Defektbereich primär unterhalb der Grenzfläche der abgeschiedenen Schicht erzeugt werden. An diese Reihenfolge der Verfahrensschritte ist man allerdings nicht gebunden. Die Herstellung der Schichtenfolge kann vorteilhaft variiert werden, beispielsweise indem man den Defektbereich vor oder nach Abscheidung einer ersten epitaktischen Schicht auf dem Substrat herstellt.

Es sei erwähnt, dass im Sinne dieser Erfindung auch weitere Schichten in Ergänzung vorgesehen sein können, beispielsweise eine in der Praxis vorliegende dünne Übergangsschicht zwischen Substrat und erster epitaktischer Schicht, die aus dem gleichen Material wie das Substrat besteht.

Die Defektbereiche können durch Ionenimplantation vorzugsweise mit leichten Ionen (Wasserstoff, Helium, Fluor, Bor, Kohlenstoff, Stickstoff, Schwefel etc.) oder Ionen des Schicht- bzw. Substratmaterials selbst, also z. B. Si oder Ge bei einer Si/SiGe Heterostruktur in der Art erfolgen, dass die Ionen primär unterhalb der ersten epitaktisch abgeschiedenen oder noch abzuscheidenden Schicht vorliegen. Die Implantation von leichten Ionen vermeidet eine zu starke Schädigung des epitaktischen Schichtsystems. Es ist vorteilhaft Ionen zu verwenden, die ungewollte Kontamination bzw. Dotierung der Struktur vermeiden. In diesem Sinne sind auch Edelgasionen (Ne, Ar, Kr etc.) einsetzbar. Die Implantationsdosis und die -tiefe werden an die Schichtdicke epitaktischen Schichtstruktur und der Masse und Energie des gewählten Ions angepasst werden. Es ist vorteilhaft, die maximale Schädigung unterhalb der ersten auf dem Substrat aufgebrachten Schicht zu erzeugen. Dies gilt insbesondere für Ionen, die zu einer Bläschen- oder Rissbildung führen (Wasserstoff, Helium, Fluor, Neon, Argon, usw.). Die Bildung von Bläschen, bzw. Hohlräumen an der Grenzfläche Substrat/epitaktische Schichtstruktur und in der epitaktischen Schichtstruktur selbst sind zu vermeiden. Ein Vorteil einer Si-Implantation im Vergleich zur Implantation mit sehr leichten Ionen (Wasserstoff oder Helium) ist es, dass die Dosis erheblich (um Faktor 100) reduziert werden kann. Dies verkürzt die Implantationszeiten und erhöht dadurch den Waferdurchsatz als eingesetztes Substrat erheblich.

Die Schichtenfolge wird thermisch so behandelt, bzw. das thermische Budget so klein gehalten, dass die implantierten Bereiche des "virtuellen Substrates" spannungsrelaxieren. Aus den Defekten, die durch die Implantation, z. B. mit Helium oder Si erzeugt wurden, entstehen beim anschließenden Tempern, Defektcluster und Versetzungen, die zum Teil vom Substrat zur epitaktischen Schichtstruktur laufen. Diese Defekte und die in der epitaktischen Schichtstruktur erzeugten bewirken eine Relaxation der Gitterverspannungen. Es entsteht in der Regel eine dünne, teilweise oder ganz spannungsrelaxierte, epitaktische Schichtstruktur mit geringen Kristallbaufehlern, die vorteilhaft als "virtuelles Substrat" eingesetzt werden kann.

Die Relaxation kann alternativ auch durch eine Oxidation mit O₂ oder Wasser ausgelöst werden. Anstelle einer rein thermischen Behandlung zur Bildung relaxierter Bereiche kann demnach eine Oxidation als Behandlung, oder auch eine Kombination von Oxidation und thermischer Behandlung eingesetzt werden. Hierdurch lässt sich auch die Konzentration von Elementen, die für die Funktionsweise des Bauelements wichtig sind, innerhalb der Schichtstruktur (z. B. Ge Anreicherung in SiGe) erhöhen.

Das Verfahren nutzt Prozessschritte, die in der Silizium-Technologie etabliert sind, so dass die Technologie auch auf sehr große Wafer (z. B. 300 mm Si-Wafer) übertragen werden kann.

Im Anschluss hieran kann erfindungsgemäß mindestens eine weitere epitaktische Schicht auf dieser Schichtenfolge abgeschieden werden. Das Substrat unterhalb der ersten epitaktischen Schichtstruktur liegt in relaxiertem Zustand vor. Das Material der weiteren epitaktisch aufgebrachten Schicht auf der epitaktischen Schichtstruktur liegt wiederum in verspanntem Zustand vor. Die weitere abgeschiedene Schicht kann aus dem gleichen Material sein wie das Substrat. Da die epitaktische Schichtstruktur regelmäßig dünn gehalten wird, z. B. kleiner als ca. 300 Nanometer, insbesondere kleiner als 200 nm, ist gewährleistet, dass eine ausgezeichnete thermische Leitfähigkeit innerhalb der gesamten Schichtenfolge erhalten wird. Die epitaktische Schichtstruktur und die darauf abgeschiedene weitere Schicht stellt auf Grund der Dünne der Schichten eine einzige Schicht in nahezu einer Ebene mit dem Substrat dar. Mit dem Begriff "in einer Ebene" ist demgemäß gemeint, dass die Höhe der durch Abscheidung entstehenden Stufen bis zur Oberfläche des Substrats nicht größer sind als der Bereich der Tiefenschärfe der Abbildungsoptik der Lithographie. Dann ist gewährleistet, dass im Zuge weiterer Verfahrensschritte die Planarität zwischen "virtuellem Substrat" und Substrat ausreichend ist. Die Schichtenfolge des virtuellen Substrates und gegebenenfalls der weiteren abgeschiedenen Schicht weist z. B. eine Dicke von ca. 100 bis 400, insbesondere 100 bis 200 Nanometer auf oder ist sogar noch dünner. Die Herstellung eines "system on a chip" (verschiedene Bauelemente mit verschiedenen Funktionen in einer Ebene) ist somit vorteilhaft im Rahmen der Erfindung möglich. Hierzu können für die Herstellung z. B. von MOSFETs zunächst das Gate-Dielektrikum (z. B. SiO₂), Source und Drain-Kontakt, der Gate-Kontakt, und gegebenenfalls Spacer sowie darunter liegende anders dotierte Kanal-, Source- und Drain-Bereiche gefertigt und in einer Passivierungsschicht bzw. Isolatorschicht eingebettet werden. Dabei ist man nicht an bestimmte Transistortypen oder Bauteile gebunden.

Anstelle eines Silizium-Substrates kann auch ein SOI Substrat (Si auf SiO₂) für die Deposition der Schichtstruktur eingesetzt werden. Die Verwendung von schwereren Ionen ist auch dann besonderes vorteilhaft, wenn die Silizium Schichtdicke auf dem Oxid so dünn wird, dass z. B. keine Wasserstoff- oder keine Heliumbläschen mehr erzeugt werden können. Dies ermöglicht eine recht kleine Gesamtschichtdicke auf dem Oxid, was z. B. für die Herstellung spezieller Bauelemente auf SOI von besonderem Vorteil ist.

Das erfindungsgemäß hergestellte Schichtsystem kann auf einen Trägerwafer durch Waferbonden übertragen werden, ohne dass ein Polieren der Oberfläche erforderlich ist. Das Abspalten des Schichtsystems kann dabei durch eine zusätzliche Wasserstoff- und/oder Heliumimplantation, sogenannter SMART-Cut Prozess erfolgen. Alternativ kann auch Abätzen eingesetzt werden. Die Abtrennung kann dann so erfolgen, dass entweder nur die weitere epitaktische Schicht oder auch die Schichtstruktur auf dem neuen Wafer, in der Regel auf SiO₂, übertragen wird. Insbesondere im Fall von Si-Ge-Schichten als Schichtstruktur können diese vorteilhaft selektiv abgeätzt werden. Dadurch kann z. B. verspanntes Silizium direkt auf SiO₂ hergestellt werden.

### Spezieller Beschreibungsteil

Nachfolgend wird der Gegenstand der Erfindung anhand von vier Figuren und Ausführungsbeispielen näher erläutert, ohne dass der Gegenstand der Erfindung dadurch beschränkt werden soll. Dabei zeigen
- Figur 1:: Schematisches Schichtsystem, umfassend ein Substrat und eine 2-lagige, epitaktisch aufgebrachte Schichtstruktur.
- Figur 2:: Schematisches Schichtsystem, umfassend ein Substrat und eine epitaktisch aufgebrachte Schichtstruktur mit einem graduellen, stetigen Konzentrationsverlauf senkrecht zur Schichtebene.
- Figur 3:: Schematisches Schichtsystem, umfassend ein Substrat und eine epitaktisch aufgebrachte Schichtstruktur mit einem graduellen, U-förmigen Konzentrationsverlauf senkrecht zur Schichtebene, sowie eine weitere verspannte Schicht.
- Figur 4:: Schematisches Schichtsystem, umfassend ein Substrat mit vergrabener Defektstruktur, eine 2-lagige, epitaktisch aufgebrachte Schichtstruktur, eine Implantationsmaske sowie eine weitere verspannte Schicht.

### Ausführungsbeispiele:

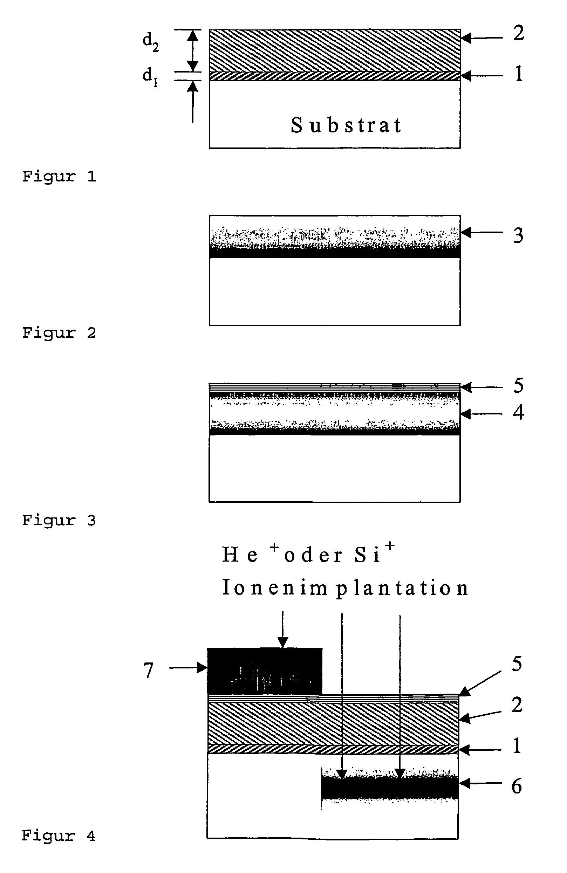

Figur 1 zeigt die Herstellung eines virtuellen Substrates mit zwei einkristallinen Schichten mit jeweils unterschiedlicher Gitterstruktur. Das Schichtwachstum erfolgt vorzugsweise mit Gasphasenepitaxie oder mit Molekularstrahlepitaxie. Auf einem Silizium-Substrat wird epitaktisch Schicht 1, beispielsweise eine reine Germaniumschicht mit wenigen Nanometern Dicke epitaktisch abgeschieden. Alternativ kann auch eine dünne Si-Ge-Schicht mit hohem Ge-Gehalt oder eine Si-C-Schicht mit 1 - 2 Atom-% Kohlenstoff verwendet werden. Anschließend wird eine Siliziumgermanium-(SiGe)-Schicht 2 mit einer Ge-Konzentration mit einer bestimmten Konzentration z. B. 30 Atom-% Ge und einer Schichtdicke d₂ von 50-250 nm abgeschieden. Es ist zu beachten, dass eine höhere Gesamtschichtdicke von Vorteil ist, da in der Regel dies zu kleineren Versetzungsdichten in dem spannungsrelaxierten virtuellen Substrat führen wird.

Alternativ dazu kann wie in Figur 2 und Figur 3 dargestellt eine Si-Ge-Schicht mit einem stark inhomogenen Konzentrationsverlauf in der Schicht aufgebracht werden. Wesentlich dabei ist, dass das Wachstum mit höherer Ge-Konzentration, evtl. sogar mit reinem Germanium, begonnen wird und dann die Konzentration (z. B. auf 30 Atom-%) abgesenkt wird. Für einen symmetrischen Spannungsaufbau kann wie in Figur 3 gezeigt in der Schicht 4 ein U-förmiger Konzentrationsverlauf verwendet werden. Ein symmetrischer Spannungsaufbau in dem Schichtsystem kann auch durch Abscheidung einer weiteren Schicht 5 auf die Schicht 2 erreicht werden, wenn diese weitere Schicht ähnliche oder gleiche Eigenschaften der Schicht 1 aufweist. Die Gesamtschichtdicke muss in allen Fällen unterhalb der Schichtdicke liegen, bei der bereits während des Wachstums Versetzungen mit störender Konzentration (maximal 10³ cm⁻²) entstehen.

Wahlweise kann auch zusätzlich eine dünne Schicht z. B. aus Silizium (Schicht 5 in Figur 4) deponiert werden. Unterhalb dieser deponierten Schichten kann ein Defektbereich z. B. durch Ionenimplantation erzeugt werden. Hierfür kann vorteilhaft eine He-Implantation mit einer Dosis von ca. 1 x 10¹⁶ cm⁻² durchgeführt werden. Die Energie der Ionen wird an die Schichtdicke so angepasst, dass die mittlere Reichweite der Ionen ca. 100-200 nm unterhalb der ersten Grenzfläche, also im Substrat liegt. Alternativ zur He-Implantation kann auch eine Si-Implantation beispielsweise mit einer Energie von ca. 150 keV und einer Dosis von etwa 1 x 10¹⁴ cm⁻² bei 100 nm Schichtdicke der Siliziumgermanium-(SiGe)-Schicht 1 und 2. Die implantierten Ionen erzeugen Kristalldefekte in und unterhalb der SiGe-Schicht.

Anschließend erfolgt für einige Minuten als thermische Behandlung eine Temperung bei 900 °C in einer inerten N₂-Atmosphäre. Es kann auch ein anderes inertes Gas (z.B. Argon) oder ein Gas, das für die Zwecke der Erfindung geeignet ist, verwendet werden (z. B. O₂ oder Formiergas). Über dem Defektbereich entsteht bei diesem Temperaturregime, das nicht zu hoch gewählt sein darf, eine spannungsrelaxierte Siliziumgermanium (SiGe)-Schichtstruktur. Diese Temper- oder Oxidationstemperatur kann an das gesamte Schichtsystem und an den Bauelementeprozess angepasst und so auf wesentlich tiefere Temperaturen abgesenkt werden. Beispielsweise kann eine Schichtrelaxation nach geeigneter Ionenimplantation bereits bei Temperaturen um 600 °C erreicht werden.

Erfindungsgemäße Schichtenfolgen auf dem Substrat können wie im ersten Ausführungsbeispiel eine Dicke von ca. 50 bis 500 Nanometer oder weniger aufweisen um diese Anforderungen zu erfüllen.

Es kann eine weitere Schicht 5, epitaktisch auf der relaxierten Siliziumgermanium-(SiGe)-Schicht 2 aufgebracht werden (Figur 4). Diese weitere Schicht 5 ist dann bei entsprechender Gitterfehlanpassung verspannt. Sie kann z. B. aus Silizium, oder auch aus Siliziumgermanium (SiGe) mit anderer Germaniumkonzentration als in der epitaktischen Schicht 2, oder auch aus einer Mehrfachschicht bestehen. Im Falle von Silizium, liegt verspanntes Silizium vor. Durch die Dünne der Schichten 1, 2 und 5 ist jedoch die Planarität im Sinn der obigen Definition der verschiedenen Bereiche der Schichten 1, 2, und 5 sowie die thermische Leitfähigkeit zum Substrat gewährleistet.

Schicht 5 aus Figur 4 (verspanntes Si) kann auf Grund der höheren Beweglichkeiten der Ladungsträger vorteilhaft zur Herstellung von ultraschnellen MOSFETs, insbesondere n-und p-Kanal MOSFETs verwendet werden.

Auch an nicht verspannten Bereichen der Schichtstruktur können vorteilhaft p-MOSFETs hergestellt werden. Diese Bereiche entstehen beispielsweise, wenn während der Ionenimplantation eine Maske verwendet wurde. Da regelmäßig nur die Bereiche der Schichtstruktur relaxieren, die oberhalb eines vergrabenen Defektbereiches eines Substrates liegen, bleiben die Bereiche der Schichtstruktur, die oberhalb der durch die Maske geschützten Bereiche des Substrates angeordnet sind regelmäßig verspannt.

Man kann darüber hinaus auch von anderen Schichtenfolgen und Prozessierungen ausgehen:

Neben Siliziumgermanium (SiGe) und Si-Ge-C und Si-C als erste epitaktische Schichten 1 und 2, bzw. 3 oder 4 können ferner allgemein III-V-Verbindungen, insbesondere III-V-Nitride (GaN, AlN, InN) sowie auch oxidische Perovskite als erste epitaktische Schichten angeordnet sein. Wichtig ist in jedem Fall nur, dass geeignete Materialien auf einem geeigneten Substrat angeordnet werden, so dass mindestens eine Schicht (5) mit unterschiedlicher Gitterstruktur, auf dem so erzeugten "virtuellen Substrat" hergestellt werden kann. Danach kann eine Herstellung der Bauelemente bis zur Herstellung der Bauelemente, z. B. Transistoren fortgeführt werden.

Die nach einem der erfindungsgemäßen Verfahren hergestellten Schichtenfolgen können insbesondere zur Herstellung von metal-oxide-semiconductor FeldeffektTransistoren (MOSFET) und modulated doped Feldeffekt-Transistor (MODFET) herangezogen werden. Es ist auch möglich resonante Tunneldioden, insbesondere eine resonante Siliziumgermanium-(SiGe)-Tunneldiode oder Quantenkaskadenlaser auf so einem "virtuellen Substrat" herzustellen. Weiterhin ist denkbar einen Photodetektor aus einer der Schichtenfolgen herzustellen. Ferner ist denkbar, ausgehend von einer Schichtenfolge von GaAs als Schicht 5 auf einem "virtuellen Substrat" aus Siliziumgermanium (SiGe) 1, 2 einen Laser herzustellen.

### Bezugszeichenliste:

- 1: Epitaktische Schicht 1, (z. B. Siliziumgermanium oder Reinstgermanium oder SiC) mit einer Schichtdicke d₁.
- 2: Epitaktische Schicht 2 (z. B. Si-Ge oder Si-Ge-C) einer bestimmten Ge-Konzentration und einer Schichtdicke d₂.
- 3: Epitaktische Si-Ge Schicht mit einem stark abfallenden Ge-Konzentrationsprofil
- 4: Epitaktische Si-Ge Schicht mit einem U-förmigen Ge-Konzentrationsprofil
- 5: Abgeschiedene Silizium- oder SiGe- oder Mehrfachschicht, z. B. verspanntes Silizium
- 6: Defektbereich im Substrat, nahe der ersten Grenzfläche zur epitaktischen Schicht.
- 7: Maske für die Ionenimplantation

## Patentansprüche

1. Verfahren zur Herstellung einer spannungsrelaxierten, einkristallinen Schichtstruktur (1, 2, 3, 4) auf einem nicht gitterangepassten Substrat, mit den Schritten
- auf einem Substrat wird epitaktisch eine einkristalline Schichtstruktur, umfassend wenigstens eine Schicht, aufgebracht, wobei die Schichtstruktur an der Grenzfläche zum Substrat eine größere Gitterparameterfehlanpassung zum Substrat aufweist als innerhalb der SchichtStruktur,
- die Gesamtschichtdicke der epitaktischen Schichtstruktur wird so gewählt, dass die Versetzungsdichte nach dem Wachstum kleiner als 10³ cm⁻² ist,
- die Schichtstruktur wird mit Ionen primär durchstrahlt, wobei in der Schichtstruktur vorwiegend Punktdefekte und im Substrat nahe der epitaktischen Schichtstruktur ein ausgedehnter Defektbereich erzeugt wird,
- die Energie der implantierten Ionen wird derart gewählt, dass die mittlere Reichweite größer als die Gesamtschichtdicke der epitaktischen Schichtstruktur ist,
- die epitaktische Schichtstruktur wird nach der Implantation im Temperaturbereich von 550 -1000°C in einer inerten, reduzierenden oder oxidierenden Atmosphäre derart behandelt, dass die Schichtstruktur oberhalb des Defektbereiches spannungsrelaxiert, eine Defektdichte kleiner als 10⁶ cm⁻² und eine Oberflächenrauhigkeit von weniger als 1 nm aufweist.

2. Verfahren nach Anspruch 1, bei dem eine Schichtstruktur aufgebracht wird, die an der Grenzfläche zum Substrat eine Gitterparameterfehlanpassung von wenigstens 1,5% aufweist.

3. Verfahren nach Anspruch 1 oder 2, bei dem eine Schichtstruktur aufgebracht wird, die an der Grenzfläche zum Substrat eine wenigstens doppelt so große Gitterparameterfehlanpassung zum Substrat aufweist als innerhalb der Schichtstruktur.

4. Verfahren nach Anspruch 1 bis 3, bei dem die Schichtstruktur oberhalb des Defektbereichs zu mindestens 60 % spannungsrelaxiert.

5. Verfahren nach Anspruch 1 bis 4, bei dem eine Schichtstruktur, umfassend Silizium-Germanium (SiGe) oder Silizium-Gemanium-Kohlenstofi (SiGeC) oder Siliciumcarbid (SiC) auf dem Substrat aufgebracht wird.

6. Verfahren nach Anspruch 5, bei dem eine Schicht mit einem abfallenden Konzentrationsprofil an Ge als Schichtstruktur auf einem Substrat aufgebracht wird.

7. Verfahren nach Anspruch 5, bei dem eine Schicht mit einem U-förmigen Konzentrationsprofil an Ge als Schichtstruktur auf einem Substrat aufgebracht wird.

8. Verfahren nach Anspruch 1 bis 4, bei dem eine Schichtstruktur, umfassend einen III-V-Verbindungshalbleiter, einen II-VI-Verbüxdungshalbleiter oder einen oxidischen Perovskiten auf dem Substrat aufgebraucht wird.

9. Verfahren nach Anspruch 1 bis 5, bei dem eine Schichtstruktur, umfassend wenigstens zwei Schichten, aufgebracht wird.

10. Verfahren nach Anspruch 9, bei dem eine erste, dünne, pseudomorphe Ge-Schicht mit einer Schichtdicke d₁, die unterhalb der kritischen Schichtdicke für pseudomorphes Wachstum von Ge auf Si liegt, und eine zweite Si₁₋ₓGeₓ Schicht (2) mit einer Dicke du >> d₁ als Schichtstruktur auf einem Substrat aufgebracht wird.

11. Verfahren nach Anspruch 9, bei dem zwei Si-Ge Schichten, als Schichtstrukrtur auf dem Substrat aufgebracht werden, einer ersten Si₁₋ₓGeₓ Schicht mit einer Dicke d₁ und einer zweiten Si_{1-y}Ge_{y} Schicht (2) mit einer Dicke d₂ und mit x > y und d₂ >> d₁.

12. Verfahren nach Anspruch 9, bei dem eine erste, dünne, pseudomorphe Si-C Schicht (1) mit einem Kohlenstoffgehalt von 1 - 2 Atom-% und einer Schichtdicke d₁ und eine zweite Si₁₋ₓGeₓ Schicht (2) mit einer Schichtdicke d₂ >> d₁ als Schichtstruktur auf einem Substrat aufgebracht wird.

13. Verfahren nach einem der Ansprüche 9 bis 12, bei dem wenigstens eine Schicht mit einem zusätzlichen Kohlenstoffgehalt von 1 - 2 Atom-% aufgebracht wird.

14. Verfahren nach einem der Ansprüche 9 bis 12, bei dem eine Schichtstruktur, umfassend wenigstens drei Schichten, aufgebracht wird.

15. Verfahren nach Anspruch 14, wobei als erste und als dritte Schicht der Schichtstruktur jeweils eine Schicht aufgebracht wird, die hinsichtlich der Zusammensetzung und der Schichtdicke identisch sind.

16. Verfahren nach einem der Ansprüche 1 bis 15, bei dem für die Implantation He Ionen mit einer Dosis von etwa 1 x 10¹⁶ cm⁻² zur Erzeugung des Defektbereichs (6) eingesetzt werden.

17. Verfahren nach einem der Ansprüche 1 bis 15, bei dem für die Implantation Si, mit einer Dosis von etwa 1 x 10¹⁴ cm⁻² zur Erzeugung des Defektbereichs (6) eingesetzt wird.

18. Verfahren nach einem der Ansprüche 1 bis 15, bei dem für die Implantation Wasserstoff-, Kohlenstoff-, Stickstoff Fluor-, Bor-, Phosphor-, Arsen-, Silizium-, Germanium-, Antimon-, Schwefel-, Neon-, Argon-, Krypton oder Xenon-Ionen zur Erzeugung des Defektbereichs (6) eingesetzt werden.

19. Verfahren nach einem der vorhergehenden Ansprüche 1 bis 18, bei dem die Ionenimplantation mit Hilfe einer lithographischen Maske (7) durchgeführt wird, so dass die Schichtstruktur nur an den implantierten Bereichen spannungsrelaxiert.

20. Verfahren nach einem der vorhergehenden Ansprüche 1 bis 19, bei dem SOI (silicon on insulator) als Substrat mit einer Si-Schicht, deren Schichtdicke unterhalb von 120 nm liegt, eingesetzt wird.

21. Verfahren nach einem der Ansprüche 1 bis 19, bei dem Silizium, Siliziumgennanium (SiGe), Siliziumcarbid (SiC), Saphir oder ein oxidischen Perovskit als Substrat eingesetzt wird.

22. Verfahren nach einem der Ansprüche 1 bis 21, bei dem auf die epitaktische Schichtstruktur eine weitere epitaktische Schicht derart vor oder nach der Ionenimpementation und der thermischen Behandlung abgeschieden wird, dass eine verspannte Schicht ausgebildet wird.

23. Verfahren nach Anspruch 1 bis 21, bei dem die epitaktische Schichtstruktur auf ein zweites Substrat gebondet wird, zumindest das erste Substrat abgetrennt wird und anschließend eine weitere epitaktisch Schicht derart auf der Schichtstruktur abgeschieden wird, dass eine verspannte Schicht ausgebildet wird.

24. Verfahren nach Anspruch 22, bei dem die weitere epitaktische Schicht auf ein zweites Substrat gebondet wird, und sodann zumindest das erste Substrat und die Schichtstruktur abgetrennt werden.

25. Verfahren nach Anspruch 22 bis 24, bei dem als weitere epitaktische Schicht eine Schicht umfassend Silizium, Siliziumgermanium (SiGe)- oder eine Si-Ge-C-Schicht oder eine Germaniumschicht abgeschieden wird.

26. Verfahren nach einem der Ansprüche 22 bis 25, bei dem an einem verspannten Silizium-Bereich als weiterer Schicht n- und/oder p-MOSFETs hergestellt werden.

27. Verfahren nach einem der vorhergehenden Ansprüche 22 bis 25, bei dem an verspannten Siliziumgermanium- (SiGe)-Bereichen als weitere epitaktische Schicht oder als nicht relaxierte Schichtstruktur p-MOSFETs hergestellt werden.

28. Verwendung eines Schichtsystems, hergestellt nach einem der vorhergehenden Ansprüche 1 bis 25, in einem Bauelement.

29. Verwendung eines Schichtsystems nach Anspruch 28, in einem modulated doped Feldeffekt-Transistor (MODFET) oder Metal-oxide-semiconductor Feldeffekt-Transistor (MOSFET) als Bauelement.

30. Verwendung eines Schichtsystems nach Anspruch 28 in einer Tunneldiode als Bauelement.

31. Verwendung eines Schichtsystems nach Anspruch 28, in einem Photodetektor als Bauelement

32. Verwendung eines Schichtsystems nach Anspruch 28 in einem Laser auf Si-Ge-Basis als Bauelement.

33. Verfahren nach Anspruch 1,
**dadurch gekennzeichnet, dass**
die epitaktische Schichtstruktur nach der Implantation im Temperaturbereich von 550 -1000°C in einer inerten, reduzierenden oder oxidierenden Atmosphäre derart behandelt wird, dass die Schichtstruktur oberhalb des Defektbereiches spannungsrelaxiert, eine Defektdichte kleiner als 10⁵ cm⁻² und eine Oberflächenrauhigkeit von weniger als 1 nm aufweist.

34. Verfahrens nach Anspruch 1 oder 2, bei dem eine Schichtstruktur aufgebracht wird, die an der Grenzfläche zum Substrat eine Gitterparameter fehlanpassung von wenigstens 2 % aufweist.

35. Verfahren nach Anspruch 1 bis 4, bei dem die Schichtstruktur oberhalb des Defektbereichs zu mindestens 70 % spannungsrelaxiert.

36. Verfahren nach Anspruch 1 bis 4, bei dem eine Schichtstruktur, umfassend ein III-V-Nitrid, einen II-VI-Verbindungshalbleitei- oder einen oxidischen Perovskiten auf dem Substrat aufgebracht wird.

37. Verfahren nach Anspruch 1 bis 21, bei dem die epitaktischen Schichtstruktur auf ein Substrat mit einer SiO₂-Schicht, gebondet wird, zumindest das erste Substrat abgetrennt wird und anschließend eine weitere epitaktische Schicht derart auf der Schichtstruktur abgeschieden wird, dass eine verspannte Schicht ausgebildet wird.

38. Verfahren nach Anspruch 22, bei dem die weitere epitaktische Schicht auf ein Substrat mit einer SiO₂-Schicht gebondet wird, und sodann zumindest das erste Substrat und die Schichtstruktur abgetrennt werden.

## Claims

1. Method for the production of a stress-relaxed, single crystalline layer structure (1, 2, 3, 4) on a non-lattice adapted substrate with the stages
- a single crystalline layer structure, comprising at least one layer, is epitactically applied to a substrate, in which the layer structure at the interface with the substrate has a greater lattice parameter mismatch to the substrate than that within the layer structure,
- the overall layer thickness of the epitactic layer structure is selected so that the displacement thickness after growth is less than 10³ cm⁻²,
- the layer structure is irradiated primarily with ions, in which predominately point defects are produced in the layer structure and an extended defect area is produced in the substrate near the epitactic layer structure,
- the energy of the implanted ions is selected in such a way that the overall coverage is greater than the overall layer thickness of the epitactic layer structure,
- after implantation the epitactic layer structure is treated in the temperature range of 550 - 1000° C in an inert, reducing or oxidising atmosphere in such a way that the layer structure above the defect area is stress-relaxed, has a defect thickness of less than 10⁶ cm⁻² and a surface roughness of less than 1 nm.

2. Method according to claim 1, in which a layer structure is applied, which has a lattice parameter mismatch of at least 1.5% at the interface with the substrate.

3. Method according to claim 1 or 2, in which a layer structure is applied, which has a lattice parameter mismatch to the substrate, which is at least double that within the layer structure, at the interface with the substrate.

4. Method according to claim 1 to 3, in which the layer structure above the defect area is at least 60% stress-relaxed.

5. Method according to claim 1 to 4, in which a layer structure comprising silicon germanium (SiGe) or silicon germanium carbon (SeGeC) or silicon carbide (SiC) is applied to the substrate.

6. Method according to claim 5, in which a layer with a decreasing concentration profile for Ge is applied to a substrate as a layer structure.

7. Method according to claim 5, in which a layer with a U-shaped concentration profile for Ge is applied to a substrate as a layer structure.

8. Method according to claim 1 to 4, in which a layer structure comprising a III-V connecting semiconductor, a II-VI-V connecting semiconductor or an oxidic perovskite is applied to the substrate.

9. Method according to claim 1 to 5, in which a layer structure comprising at least two layers is applied.

10. Method according to claim 9, in which a first, thin, pseudomorphous Ge layer with a layer thickness d₁, which is below the critical layer thickness for pseudomorphous growth of Ge on Si, and a second Si₁₋ₓGeₓ layer (2) with a thickness d₂ >> d₁ is applied to a substrate as a layer structure.

11. Method according to claim 9, in which two Si-Ge layers are applied to the substrate as a layer structure, a first Si₁₋ₓGeₓ layer with a thickness d₁ and a second Si_{1-y}Ge_{y} layer (2) with a thickness d₂ and with x > y and d₂ >> d₁.

12. Method according to claim 9, in which a first, thin, pseudomorphous Si-C layer (1) with a carbon content of 1 - 2 atomic percent and a layer thickness d₁ and a second Si₁₋ₓGeₓ layer (2) with a layer thickness d₂ >> d₁ is applied to a substrate as a layer structure.

13. Method according to one of claims 9 to 12, in which at least one layer with an additional carbon content of 1 - 2 atomic percent is applied.

14. Method according to one of claims 9 to 12, in which a layer structure comprising at least three layers is applied.

15. Method according to claim 14, in which a layer is applied as the first and third layer of the layer structure, which is identical with reference to composition and layer thickness.

16. Method according to one of claims 1 to 15, in which He ions with a dose of about 1 x 10¹⁶ cm⁻² are used for implantation to create the defect area (6).

17. Method according to one of claims 1 to 15, in which Si with a dose of about 1 x 10¹⁴ cm⁻² is used for implantation to create the defect area (6).

18. Method according to one of claims 1 to 15, in which hydrogen, carbon, nitrogen, fluorine, boron, phosphor, arsenic, silicon, germanium, antimony, sulphur, neon, argon, krypton or xenon ions are used for implantation to create the defect area (6).

19. Method according to one of the previous claims 1 to 18, in which ion implantation is carried out using a lithographic mask (7) so that the layer structure is only stress-relaxed on the implanted areas.

20. Method according to one of the previous claims 1 to 19, in which SOI (silicon on insulator) is used as a substrate with an Si layer, the layer thickness of which is less than 120 nm.

21. Method according to one of claims 1 to 19, in which silicon, silicon germanium (SiGe), silicon carbide (SiC), sapphire or an oxidic perovskite is used as a substrate.

22. Method according to one of claims 1 to 21, in which a further epitactic layer is deposited on the epitactic layer structure before or after ion implementation and thermal treatment in such a way that a stressed layer is formed.

23. Method according to claim 1 to 21, in which the epitactic layer structure is bonded on a second substrate, at least the first substrate is separated and then a further epitactic layer is deposited on the layer structure in such a way that a stressed layer is formed.

24. Method according to claim 22, in which the further epitactic layer is bonded on a second substrate and then at least the first substrate and the layer structure are separated.

25. Method according to claim 22 to 24, in which a layer comprising silicon, silicon germanium (SiGe) or an Si-Ge-C layer or a germanium layer is deposited as a further epitactic layer.

26. Method according to one of claims 22 to 25, in which n- and/or p-MOSFETs are produced as a further layer on a stressed silicon area.

27. Method according to one of the previous claims 22 to 25, in which p-MOSFETs are produced on stressed silicon germanium (SiGe) areas as a further epitactic layer or as a non-relaxed layer structure.

28. Use of a layer structure, produced according to one of the previous claims 1 to 25, in a component.

29. Use of a layer structure according to claim 28 as a component in a modulated doped field effect transistor (MODFET) or metal oxide semiconductor field effect transistor (MOSFET).

30. Use of a layer system according to claim 28 as a component in a tunnel diode.

31. Use of a layer system according to claim 28 as a component in a photodetector.

32. Use of a layer system according to claim 28 as a component in a laser on an Si-Ge basis.

33. Method according to claim 1,
**characterised in that**
after implantation the epitactic layer structure is treated in the temperature range of 550 - 10000° C in an inert, reducing or oxidising atmosphere in such a way that the layer structure above the defect area is stress-relaxed, has a defect thickness of less than 10⁵ cm⁻² and a surface roughness of less than 1 nm.

34. Method according to claim 1 or 2, in which a layer structure is applied, which has a lattice parameter mismatch of at least 2% at the interface with the substrate.

35. Method according to claim 1 to 4, in which the layer structure above the defect area is at least 70% stress-relaxed.

36. Method according to claim 1 to 4, in which a layer structure comprising a III-V nitride, a II-VI-V connecting semiconductor or an oxidic perovskite is applied to the substrate.

37. Method according to claim 1 to 21, in which the epitactic layer structure is bonded to a substrate with an SiO₂ layer, at least the first substrate is separated and then a further epitactic layer is deposited on the layer structure in such a way that a stressed layer is formed.

38. Method according to claim 22, in which the further epitactic layer is bonded on a substrate with an SiO₂ layer and then at least the first substrate and the layer structure are separated.

## Revendications

1. Procédé de production d'une structure lamellaire cristalline libérant la contrainte (1, 2, 3, 4) sur un substrat non adapté en grille, comportant les étapes suivantes :
- sur un substrat est appliquée de façon épitactique une structure lamellaire cristalline comprenant au moins une couche, la structure lamellaire présentant sur la surface intermédiaire du substrat, une inadaptation des paramètres de grille plus grande par rapport au substrat qu'à l'intérieur de la structure lamellaire,
- l'épaisseur de couche totale de la structure lamellaire épitactique est choisie de telle sorte que la densité des dislocations après la croissance soit inférieure à 10³ cm⁻²,
- la structure lamellaire est traversée initialement par des ions, des défauts ponctuels principalement dans la structure lamellaire et une zone de défaut étendue dans le substrat proche de la structure lamellaire épitactique étant produits,
- l'énergie des ions implantés est choisie de telle sorte que la portée moyenne soit supérieure à l'épaisseur totale des couches de la structure lamellaire épitactique,
- la structure lamellaire épitactique est traitée après implantation dans une plage de températures de 550 à 1000° C dans une atmosphère inerte, réductrice ou oxydante de telle sorte que la structure lamellaire présente au-dessus de la zone de défaut en libérant la contrainte, une densité de défaut inférieure à 10⁶ cm⁻² et une rugosité de surface inférieure à 1 nm.

2. Procédé selon la revendication 1, dans lequel une structure lamellaire est appliquée, qui présente sur la surface intermédiaire du substrat, une inadaptation des paramètres de grille inférieure à 1,5 %.

3. Procédé selon la revendication 1 ou 2, dans lequel une structure lamellaire est appliquée, qui présente sur la surface intermédiaire du substrat, une inadaptation des paramètres de grille vers le substrat au moins deux fois plus grande qu'à l'intérieur de la structure lamellaire.

4. Procédé selon la revendication 1 à 3, dans lequel la structure lamellaire présente au-dessus de la zone de défaut, un relâchement de la contrainte d'au moins 60 %.

5. Procédé selon la revendication 1 à 4, dans lequel une structure lamellaire comprenant du silicium-germanium (SiGe) ou du silicium-germanium-carbone (SiGeC) ou du carbure de silicium (SiC) est appliquée sur le substrat.

6. Procédé selon la revendication 5, dans lequel une couche présentant un profil de concentration de Ge diminuant est appliquée en tant que structure lamellaire sur un substrat.

7. Procédé selon la revendication 5, dans lequel une couche présentant un profil de concentration de Ge en forme de U est appliquée en tant que structure lamellaire sur un substrat.

8. Procédé selon la revendication 1 à 4, dans lequel une structure lamellaire comprenant un semi-conducteur composé III-V, un semi-conducteur composé II-VI ou une perovskite oxydée est appliquée sur le substrat.

9. Procédé selon la revendication 1 à 5, dans lequel une structure lamellaire comprenant au moins deux couches est appliquée.

10. Procédé selon la revendication 9, dans lequel une première couche de Ge fine, pseudomorphe, présentant une épaisseur de couche d₁ qui se situe sous l'épaisseur de couche déterminante pour une croissance pseudomorphe de Ge sur Si et une deuxième couche Si₁ₓGeₓ (2) présentant une épaisseur d₂>>d₁ est appliquée en tant que structure lamellaire sur un substrat.

11. Procédé selon la revendication 9, dans lequel deux couches de Si-Ge sont appliquées en tant que structure lamellaire sur le substrat, une première couche de Si₁₋ₓGeₓ présentant une épaisseur d₁ et une deuxième couche (2) Si_{1-y}Ge_{y} présentant une épaisseur d₂ et sachant que x > y et d₂ >>d₁.

12. Procédé selon la revendication 9, dans lequel une première couche fine de Si-C pseudomorphe (1) présentant une teneur en carbone de 1 à 2 % d'atome et une épaisseur de couche d₁ et une deuxième couche Si₁₋ₓGeₓ (2) présentant une épaisseur de couche d₂ >> d₁ est appliquée en tant que structure lamellaire sur un substrat.

13. Procédé selon l'une des revendications 9 à 12, dans lequel au moins une couche présentant une teneur en carbone supplémentaire de 1 à 2 % d'atome est appliquée.

14. Procédé selon l'une des revendications 9 à 12, dans lequel une structure lamellaire comprenant au moins trois couches est appliquée.

15. Procédé selon la revendication 14, dans lequel est appliquée, comme première et comme troisième couches de la structure lamellaire, respectivement, une couche qui est identique en termes de composition et d'épaisseur de couche.

16. Procédé selon l'une des revendications 1 à 15, dans lequel pour l'implantation, on utilise des ions He en une dose d'environ 1 x 10¹⁶ cm⁻² pour générer une zone de défaut (6).

17. Procédé selon l'une des revendications 1 à 15, dans lequel pour l'implantation, on utilise du Si à une dose d'environ 1 x 10¹⁴ cm⁻² pour générer la zone de défaut (6).

18. Procédé selon l'une des revendications 1 à 15, dans lequel pour l'implantation, on utilise des ions hydrogène, carbone, azote, fluor, borne, phosphore, arsenic, silicium, germanium, antimoine, soufre, néon, argon, crypton ou xénon de la zone de défaut (6).

19. Procédé selon l'une des revendications 1 à 18 précédentes, dans lequel l'implantation des ions s'effectue à l'aide d'un masque lithographique (7) de sorte que la structure lamellaire ne présente un relâchement des contraintes que dans les zones implantées.

20. Procédé selon l'une des revendications 1 à 19 précédentes, dans lequel on utilise du SOI (silicium sur isolant) comme substrat avec une couche de Si dont l'épaisseur de couche est inférieure à 120 nm.

21. Procédé selon l'une des revendications 1 à 19, dans lequel on utilise comme substrat le silicium, le silicium-germanium (SiGe), le carbure de silicium (SiC), le saphir ou une perovskite oxydée.

22. Procédé selon l'une des revendications 1 à 21, dans lequel est déposée sur la structure lamellaire épitactique, une autre couche épitactique avant ou après l'implantation d'ions et le traitement thermique de telle sorte qu'une couche tendue soit formée.

23. Procédé selon la revendication 1 à 21, dans lequel la structure lamellaire épitactique est fixée sur un deuxième substrat, au moins le premier substrat est séparé et ensuite, une autre couche épitactique est déposée sur la structure lamellaire de telle sorte qu'une couche tendue soit formée.

24. Procédé selon la revendication 22, dans lequel l'autre couche épitactique est fixée sur un deuxième substrat et ensuite, au moins le premier substrat et la structure lamellaire sont séparés.

25. Procédé selon la revendication 22 à 24, dans lequel on dépose comme autre couche épitactique, une couche comprenant du silicium, du silicium-germanium (SiGe) ou une couche de Si-Ge-C ou une couche de germanium.

26. Procédé selon l'une des revendications 22 à 25, dans lequel sur une zone de silicium tendue en tant qu'autre couche, non produit des n- et/ou p-MOSFET.

27. Procédé selon l'une des revendications précédentes 22 à 25, dans lequel sur des zones tendues de silicium-germanium (SiGe), on produit comme autre couche épitactique ou comme structure lamellaire non relâchée, des p-MOSFET.

28. Utilisation d'un système lamellaire fabriqué selon l'une des revendications précédentes 1 à 25, dans un composant.

29. Utilisation d'un système lamellaire selon la revendication 28, dans un transistor à modulation de dopage (MODFET) ou un transistor MOS (MOSFET) comme composant.

30. Utilisation d'un système lamellaire selon la revendication 28 dans une diode tunnel comme composant.

31. Utilisation d'un système lamellaire selon la revendication 28, dans un photodétecteur comme composant.

32. Utilisation d'un système lamellaire selon la revendication 28, dans un laser à base de Si-Ge comme composant.

33. Procédé selon la revendication 1,
**caractérisé en ce que** la structure lamellaire épitactique est traitée après l'implantation dans une plage de températures de 550 à 1000° C dans une atmosphère inerte, réductrice ou oxydante de telle sorte que la structure lamellaire présente une libération de contraintes au-dessus de la zone de défaut, une densité de défaut inférieure à 10⁵ cm⁻² et une rugosité de surface inférieure à 1 nm.

34. Procédé selon la revendication 1 ou 2, dans lequel une structure lamellaire est appliquée, qui présente sur la surface intermédiaire du substrat, une inadaptation des paramètres de grille d'au moins 2 %.

35. Procédé selon la revendication 1 à 4, dans lequel la structure lamellaire présente un relâchement de la contrainte au-dessus de la zone de défaut, d'au moins 70 %.

36. Procédé selon la revendication 1 à 4, dans lequel une structure lamellaire comprenant un nitrure III-V, un semi-conducteur composé II-VI ou une perovskite oxydées est appliquée sur le substrat.

37. Procédé selon la revendication 1 à 21, dans lequel la structure lamellaire épitactique est fixée sur un substrat avec une couche de SiO₂, au moins le premier substrat est séparé et ensuite, une autre couche épitactique est déposée sur la structure lamellaire de telle sorte qu'une couche tendue soit formée.

38. Procédé selon la revendication 22, dans lequel l'autre couche épitactique est fixée sur un substrat avec une couche de SiO₂, au moins le premier substrat et la structure lamellaire étant ensuite séparés.
